# EUROPEAN PATENT APPLICATION

(11) **EP 4 848 952 A1**
(43) Date of publication of application: **02.12.2026**
(21) Application number: 25745381.1
(22) Date of filing: 24.01.2025
(51) Int. Cl.: H10H 29/85, H10H 29/14, H10H 29/24, H10H 29/41, H10H 29/49, H10H 29/853

(54) **LIGHT-EMITTING MODULE**

(30) Priority: 26.01.2024 US 202463625517 P; 22.01.2025 US 202519034244
(71) Applicant: Seoul Viosys Co., Ltd., Ansan-si, Gyeonggi-do 15429 (KR)
(72) Inventor: CHA, Nam Goo, Ansan-Si Gyeonggi-do 15429 (KR)
(74) Representative: Stolmár & Partner Patentanwälte PartG mbB
(86) International application number: PCT/KR2025/001441
(87) International publication number: WO 2025/159559

(57) **Abstract**

The present disclosure discloses a light emitting module including at least one light emitting device, the light emitting device comprising a first conductivity type semiconductor layer, a second conductivity type semiconductor layer, an active layer disposed between the first conductivity type semiconductor layer and the second conductivity type semiconductor layer, and an electron blocking layer disposed between the active layer and the second conductivity type semiconductor layer, where the electron blocking layer includes at least one shading region having a smaller thickness than that of an adjacent region.

## Description

### [Technical Field]

The present disclosure relates to a light emitting module including a light emitting device.

### [Background Art]

A light emitting diode (LED) is one of the light emitting devices that emit light when current is applied. Recently, the light emitting diode has been widely used in various technical fields such as display apparatuses, vehicle lamps, and general lighting. Moreover, the light emitting diode has advantages of long life, low power consumption, and fast response speed. By taking full advantage of these advantages, it has rapidly replaced a conventional light source. As an example, a display device using the light emitting diode may be obtained by forming structures of individually grown red R, green G, and blue B light emitting diodes (LEDs) on a final substrate.

In detail, the light emitting diode is formed by growing epitaxial layers on a substrate, and includes an n-type semiconductor layer, a p-type semiconductor layer, and an active layer interposed therebetween. An n-electrode pad is formed on the n-type semiconductor layer, and a p-electrode pad is formed on the p-type semiconductor layer, so that the light emitting diode is driven by being electrically connected to an external power source through the electrode pads. In this case, current can flow from the p-electrode pad through the semiconductor layers to the n-electrode pad, and light generated through the recombination of electrons and holes in the active layer may be emitted.

In general, a display apparatus displays various colors using a mixture of blue, green, and red. In order to realize various images, the display apparatus includes a plurality of pixels, each including sub-pixels corresponding to one of blue, green, and red light. As such, a color of a certain pixel is typically determined based on the colors of the sub-pixels, so that images can be realized through the combination of such pixels.

Recently, attempts have been made to utilize an ultra-small micro LED, which is 1/10 the size of a conventional mini LED, in a display. A micro LED is an LED with a device size of less than 100 µm in width and length, and in order for the micro LED to be applied to a small display apparatus, the device size needs to be reduced to 5 µm to 10 µm. A display in which the micro LED is employed has superior performance in almost all aspects including contrast ratio, response speed, color reproducibility, beam angle, brightness, maximum resolution, lifespan, and others, compared to a display using a conventional LED backlight, because the LED itself emits light.

### [Disclosure]

### [Technical Problem]

The present disclosure aims to provide a light emitting module that is configured to stably mount a light emitting device on a substrate without a damage or tilting of the light emitting device, thereby reducing a defect rate.

The present disclosure aims to provide, by mounting a light emitting device on a substrate using a spacer including particles, a light emitting module that is configured to effectively dissipate heat generated when the light emitting device is driven through the particles and to prevent the light emitting device from being damaged by heat.

The present disclosure aims to provide, by mounting a light emitting device on a substrate using a spacer including particles, a light emitting module that is configured to effectively dissipate heat generated when the light emitting device is driven through the particles and to prevent the light emitting device from being peeled off or damaged by heat.

The present disclosure aims to provide a light emitting module with improved performance and reliability and high light extraction efficiency.

### [Technical Solution]

A light emitting module according to an embodiment of the present disclosure includes a substrate, a plurality of light emitting devices, and a spacer disposed between one surface of the substrate and the plurality of light emitting devices.

In an embodiment, the spacer may include a plurality of particles.

In an embodiment, diameters of the plurality of particles may be smaller than a maximum thickness of a semiconductor layer of the light emitting device.

In an embodiment, the spacer may further include a polymer layer surrounding the plurality of particles.

In an embodiment, an upper surface of the polymer layer between the plurality of light emitting devices may coincide with an upper surface of the light emitting device.

In an embodiment, the plurality of particles may be disposed under the spacer.

In an embodiment, separation distances between the plurality of particles may be different from one another.

In an embodiment, the diameters of the plurality of particles may be different from one another.

In an embodiment, with respect to a virtual line passing through a midpoint between the upper surface of the light emitting device on one surface of the substrate, centers of the plurality of particles may be positioned on or below the virtual line.

In an embodiment, the substrate may include an electrode layer including a substrate electrode electrically connected to an electrode pad of the light emitting device, a main insulation layer disposed under the electrode layer, and a cover layer disposed over the electrode layer.

In an embodiment, the cover layer may include an opening vertically penetrated for the plurality of light emitting devices to be disposed.

In an embodiment, two or more light emitting devices may be disposed in the opening.

In an embodiment, a thickness of the cover layer may be smaller than the diameter of the particle.

In an embodiment, on the cover layer, the diameter of the particle may be larger than a vertical distance from the particle to the upper surface of the polymer layer.

In an embodiment, the light emitting device has a rectangular shape having a long side and a short side on a plane, and two or more light emitting devices may be spaced apart from each other along a long side direction within the opening.

In an embodiment, the particles disposed over the cover layer may be positioned higher than the particles positioned between the light emitting devices within the opening.

In an embodiment, a thermal expansion coefficient of the particle may be smaller than that of the electrode pad of the light emitting device.

In an embodiment, the particle may include a core layer and an outer layer surrounding the core layer and having a material different from that of the core layer.

In an embodiment, the particle may be a sphere having a center point.

In an embodiment, irregularities may be formed on an outer surface of the particle.

In an embodiment, portions of the plurality of particles may be disposed between the electrode pad of the light emitting device and one surface of the substrate, and the electrode pad may have a concave surface formed on a surface facing the substrate.

In an embodiment, a step structure may be formed on the concave surface.

In an embodiment, the light emitting device may include a first conductivity type semiconductor layer, a second conductivity type semiconductor layer, an active layer disposed between the first conductivity type semiconductor layer and the second conductivity type semiconductor layer, a first electrode pad disposed on an exposed region of the first conductivity type semiconductor layer that is exposed by etching the second conductivity type semiconductor layer and the active layer, and a second electrode pad disposed on the second conductivity type semiconductor layer.

In an embodiment, a thickness of the spacer between the first electrode pad and one surface of the substrate may be larger than that of the spacer between the second electrode pad and one surface of the substrate.

### [Advantageous Effect]

The present disclosure may provide a light emitting module that is configured to stably mount a light emitting device on a substrate without a damage or tilting of the light emitting device, thereby reducing a defect rate.

The present disclosure may provide, by mounting a light emitting device on a substrate using a spacer including particles, a light emitting module that is configured to effectively dissipate heat generated when the light emitting device is driven through the particles and to prevent the light emitting device from being damaged by heat.

The present disclosure may provide, by mounting a light emitting device on a substrate using a spacer including particles, a light emitting module that is configured to effectively dissipate heat generated when the light emitting device is driven through the particles and to prevent the light emitting device from being peeled off or damaged by heat.

The present disclosure may provide a light emitting module with improved performance and reliability and high light extraction efficiency.

### [Description of Drawings]

FIG. 1 is a plan view showing a light emitting module according to an embodiment of the present disclosure.
FIG. 2 is a cross-sectional view taken along line A-A' of FIG. 1.
FIG. 3 is a cross-sectional view taken along line B-B' of FIG. 1.
FIG. 4 is a cross-sectional view showing particles of FIGs. 2 and 3.
FIG. 5 is a cross-sectional view showing a light emitting device disposed in the light emitting module of FIG. 1.
FIG. 6 is a cross-sectional view showing a modified example of an electrode pad of the light emitting device of FIG. 5.
FIG. 7 is a cross-sectional view showing a portion of a light emitting module according to another embodiment of the present disclosure.
FIG. 8 is a plan view showing a portion of a light emitting module according to another embodiment of the present disclosure.

### [Best Mode]

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

Hereinafter, a light emitting module of the present disclosure will be described in detail through drawings.

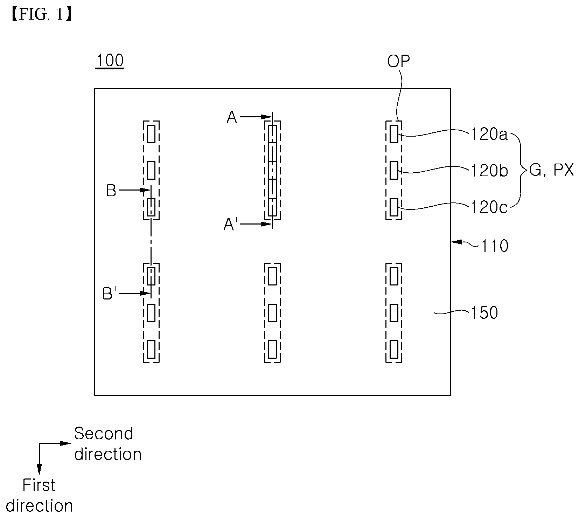

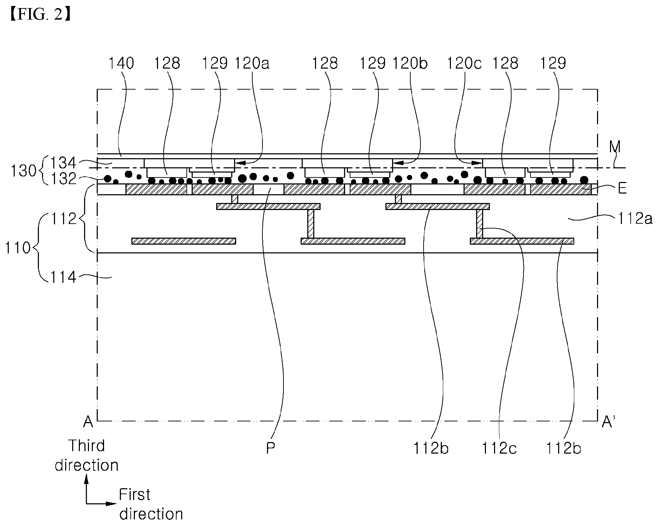

Referring to FIGs. 1 and 2, the present disclosure may provide a light emitting module 100 including a substrate 110, a plurality of light emitting devices 120a, 120b, and 120c, and a spacer 130 disposed between one surface of the substrate 110 and the plurality of light emitting devices 120a, 120b, and 120c. Hereinafter, preferred embodiments of the present disclosure will be described in more detail with reference to the accompanying drawings.

The substrate 110 is a substrate that the light emitting devices 120a, 120b, and 120c are mounted on one surface, and is not limited to a particular type as long as it can support the light emitting devices 120a, 120b, and 120c, such as a circuit board, a lead frame, a flexible substrate, a transparent substrate, and others. The substrate 110 supports the plurality of light emitting devices 120a, 120b, and 120c and may be electrically connected to the plurality of light emitting devices 120a, 120b, and 120c.

The substrate 110 may have a flat shape, without being limited thereto.

As an example, the substrate 110 may be formed of PCB (Printed Circuit Board). The PCB may be, for example, an FR4 PCB which has excellent characteristics such as high strength, flame retardancy, chemical resistance, or others. Alternatively, the substrate 100 may be at least one of a PMMA (Polymethyl Methacrylate), PC (Polycarbonate) resin, COP (Cyclo Olefin Polymer), acrylic resin, PE (Polyethylene), epoxy resin, and glass, which have light-transmitting characteristics. Alternatively, the substrate 100 may be formed of a material having a bendable property, such as PET or PVB. Alternatively, the substrate 100 may be a Metal PCB (Metal Printed Circuit Board) having excellent heat dissipation performance and favorable thermal conductivity. In more detail, it may be a PCB including Cu, Zn, Au, Ni, Al, Mg, Cd, Be, W, Mo, Si and Fe or an alloy of at least one of these as a base metal. However, the inventive concepts are not limited thereto, and various PCBs may be used depending on product characteristics.

A refractive index of the substrate 110 may be different from that of a first conductivity type semiconductor layer 121, a second conductivity type semiconductor layer 122 or an active layer 123 of the light emitting devices 120a, 120b, and 120c. The substrate 110 may be transparent to light generated from the light emitting devices 120a, 120b, and 120c or may be transparent to light generated externally. A luminous intensity of light sensed from one surface of the substrate 110 may have a value different from that of light sensed from the other surface (a surface opposite to one surface) of the substrate 110. A light emission pattern in a direction of one side of the substrate 110 may be different from that on the other surface (the surface opposite to one surface) of the substrate 110. A beam angle in the direction of one surface of the substrate 110 may be different from that on the other surface (the surface opposite to one surface) of the substrate 110. A surface uniformity (or roughness, RMS) on one surface of the substrate 110 may be different from a surface uniformity (or roughness, RMS) on the other surface. Therefore, optical characteristics on one surface of the substrate 110 and optical characteristics on the other surface may be controlled differently.

The substrate 110 may be formed in a single-layer or multi-layer structure, and may be formed in various thicknesses as needed.

For example, when the substrate 110 is formed in the multi-layer structure, the substrate 110 may include an electrode layer 112 electrically connected to the light emitting devices 120a, 120b, and 120c and a main insulation layer 114 disposed on one side of the electrode layer 112. The substrate 110 may further include an electrode layer disposed on one side of the main insulation layer 114.

The electrode layer 112 may include a substrate electrode layer disposed on a surface facing the light emitting devices 120a, 120b, and 120c and an interconnection layer under the substrate electrode layer.

The substrate electrode layer may include a substrate electrode E electrically connected to the light emitting devices 120a, 120b, and 120c. The substrate electrode layer may include the substrate electrode E and an insulation layer P disposed between the substrate electrode E. The substrate electrode E may be an individual electrode individually provided for each of the light emitting devices 120a, 120b, and 120c or a common electrode commonly connected to the plurality of light emitting devices 120a, 120b, and 120c.

The interconnection layer may include an insulation layer 112a disposed under the substrate electrode E, a metal interconnection 122b provided within the insulation layer 112a, and a connection electrode 112c connecting the substrate electrode E and the metal interconnection 112b through a via hole. The substrate 110 may be formed of a glass fiber reinforced epoxy resin laminate as a FR4 material. When the substrate 110 is formed in the multi-layer structure, complex interconnection may be overlapped vertically, thereby increasing a degree of circuit integration.

The insulation layer 114 is a main insulation layer which may be formed of various materials, and for example, may be formed of glass material.

On an upper surface of the substrate 110, the plurality of light emitting devices 120a, 120b, and 120c may be arranged in various patterns. For example, three light emitting devices 120a, 120b, and 120c that emit red, green, and blue light, respectively, may be disposed at regular intervals to form one group G or pixel PX. The plurality of light emitting devices 120a, 120b, and 120c may reproduce light of a wide color range using red, green, and blue light. Alternatively, it is also possible to have red, green, and blue light emitting diodes vertically stacked on a single light emitting device 120a, 120b, or 120c to form one group G or pixel. In addition, the light emitting devices 120a, 120b, and 120c may be formed of diode devices that emit light of a same color range. For example, they may be formed of light emitting devices 120a, 120b, and 120c having a difference in dominant wavelength between adjacent light emitting devices 120a, 120b, and 120c of about 2 nm to 15 nm, thereby implementing more vivid colors.

The light emitting devices 120a, 120b, and 120c may have a rectangular shape having a long side and a short side on a plane. For example, referring to FIG. 1, the light emitting devices 120a, 120b, and 120c may have a long side parallel to a first direction and a short side parallel to a second direction perpendicular to the first direction.

When three light emitting devices 120a, 120b, and 120c constitute one group G or pixel PX, the light emitting devices 120a, 120b, and 120c may be disposed along a long side direction (the first direction). Therefore, by disposing the short sides of the light emitting devices 120a, 120b, and 120c within one group G or pixel PX to face one another such that lengths or areas of facing surfaces are relatively short, an influence of light on the adjacent light emitting devices 120a, 120b, and 120c may be reduced.

The plurality of light emitting devices 120a, 120b, and 120c may be grouped to form a plurality of groups G or pixels PX. The plurality of groups G or pixels PX may be arranged in a grid shape on the substrate 110. A separation distance between first direction reference groups G or pixels PX may be smaller than a separation distance between second direction reference groups G or pixels PX. The separation distance between the first direction reference groups G or pixels PX may be greater than a separation distance between the light emitting devices 120a, 120b, and 120c within one group G or pixel PX.

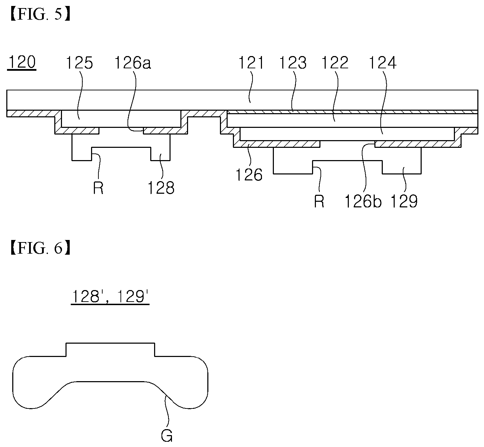

The light emitting devices 120a, 120b, and 120c are light emitting diode devices that are disposed on one surface of the substrate 110 to emit light, and may be configured in various ways. As an example, the light emitting devices 120a, 120b, and 120c may be configured identically or similarly to a light emitting device 120 of FIG. 5. Referring to FIG. 5, the light emitting device 120 may include semiconductor layers 121, 122, and 123 formed on a growth substrate.

The growth substrate is not limited as long as it is a substrate capable of growing a nitride-based semiconductor, and may include, for example, a heterogeneous substrate such as a sapphire substrate, a gallium arsenide substrate, a silicon substrate, a silicon carbide substrate or a spinel substrate, and in addition, may include a homogeneous substrate such as a gallium nitride substrate, an aluminum nitride substrate, or the like. The growth substrate may be removed after the semiconductor layer is grown. FIG. 5 illustrates the light emitting device 120 from which the growth substrate is removed, but the growth substrate is not necessarily removed. As a size of the light emitting device 120 decreases, a possibility of breakage or damage to the light emitting device 120 may increase, and thus stable mounting is required and reliability needs to be secured during operation.

Referring to FIG. 5, the light emitting device 120 may include a first conductivity type semiconductor layer 121, a second conductivity type semiconductor layer 122, and an active layer 123 disposed between the first conductivity type semiconductor layer 121 and the second conductivity type semiconductor layer 122.

The first conductivity type semiconductor layer 121 may be a semiconductor layer grown on one surface of the growth substrate, and a buffer layer (not shown in the drawings) may be further formed between the first conductivity type semiconductor layer 121 and the growth substrate.

The first conductivity type semiconductor layer 121 may include a phosphide or nitride semiconductor such as (Al, Ga, In)P or (Al, Ga, In)N, and may be formed by being grown on the growth substrate using a method such as MOCVD, MBE, HVPE, or the like. In addition, the first conductivity type semiconductor layer 121 may be doped as n-type by including one or more impurities such as Si, C, Ge, Sn, Te, Pb, or others. However, without being limited thereto, the first conductivity type semiconductor layer 121 may be doped with an opposite conductivity type, including a p-type dopant. In addition, the first conductivity type semiconductor layer 121, furthermore, may be formed of a single layer or multiple layers.

The active layer 123 is a light emitting layer disposed on one side of the first conductivity type semiconductor layer 121, and may include a phosphide or nitride semiconductor such as (Al, Ga, In)P or (Al, Ga, In)N, and may be grown on the first conductivity type semiconductor layer 121 using a technique such as MOCVD, MBE, HVPE, or the like.

In addition, the active layer 123 may include a quantum well structure (QW) including at least two barrier layers and at least one well layer, and further, may include a multiple quantum well structure (MQW) including a plurality of barrier layers and a plurality of well layers.

A wavelength of light emitted from the active layer 123 may be adjusted by controlling a composition ratio of materials forming the well layer. In this case, the well layers may include same elements in common, and for example, may include In.

The second conductivity type semiconductor layer 122 may be a semiconductor layer disposed on one side of the active layer 123. The second conductivity type semiconductor layer 122 may include a phosphide or nitride semiconductor such as (Al, Ga, In)P or (Al, Ga, In)N, and may be grown using the technique such as MOCVD, MBE, HVPE, or the like. The second conductivity type semiconductor layer 122 may be doped with a conductive type opposite to that of the first conductivity type semiconductor layer 121. For example, the second conductivity type semiconductor layer 122 may be doped as a p-type including an impurity such as Mg.

The light emitting device 120 may have a light-exiting surface formed on a side of the first conductivity type semiconductor layer 121 or the second conductivity type semiconductor layer 122 from which light is emitted. As an example, light generated in the active layer 123 may be emitted to the outside through the first conductivity type semiconductor layer 121, or may be emitted to the outside through the second conductivity type semiconductor layer 122. An irregularity structure may be formed on one surface of the first conductivity type semiconductor layer 121 or one surface of the second conductivity type semiconductor layer 122 to increase light extraction efficiency.

The light emitting device 120 may include a mesa in which portions of the second conductivity type semiconductor layer 122 and the active layer 123 are etched to expose a portion of the first conductivity type semiconductor layer 121. The light emitting device 120 may include a metallic layer 125 disposed on an exposed region of the first conductivity type semiconductor layer 121.

In addition, the light emitting device 120 may include an ohmic electrode 124 disposed on one surface of the second conductivity type semiconductor layer 122 and an insulation layer 126 covering the first conductivity type semiconductor layer 121 and the second conductivity type semiconductor layer 122. The insulation layer 126 may include a first opening 126a exposing a portion of the metallic layer 125 and a second opening 126b exposing a portion of the ohmic electrode 124. The insulation layer 126 may be formed of a single layer or a plurality of layers.

In addition, the light emitting device 120 may include a first electrode pad 128 connected to the metallic layer 125 through the first opening 126a and a second electrode pad 129 connected to the ohmic electrode 124 through the second opening 126b.

The light emitting device 120 may be driven by being electrically connected to an external power source through the first electrode pad 128 and the second electrode pad 129. In this case, current may flow from the second electrode pad 129 through the semiconductor layers 122, 123, and 121 to the first electrode pad 128, and light may be generated through the recombination of electrons and holes in the active layer 123.

The first electrode pad 128 and the second electrode pad 129 are configured to mount the light emitting device 200 on the substrate electrode E of the substrate 110, and may be formed of a suitable material. For example, the first and second electrode pads 128 and 129 may include Au.

The first and second electrode pads 128 and 129 may include a material having a resistivity of 1×10⁻⁴Ω·cm or less to supply current to the first and second conductivity type semiconductor layers 121 and 122 of the light emitting device 120. To satisfy this condition, the first and second electrode pads 128 and 129 may be made of a metallic material such as copper, gold, silver, tin, iron, aluminum, or the like. Alternatively, the first and second electrode pads 128 and 129 may be formed of a transparent electrode made of a compound of the metal or an oxide such as indium tin oxide (ITO) or manganese oxide, a conductive polymer (PEDOT:PSS, Poly(3,4-ethylenedioxythiophene):poly(styrenesulfonate)), a nanowire such as a silver nanowire or a carbon nanotube, or others.

Meanwhile, a concave surface R sunken inwardly may be formed on a surface of the first and second electrode pads 128 and 129 facing the substrate 110.

As illustrated in FIG. 5, a step structure may be formed on the concave surface R, but the inventive concepts are not limited thereto. FIG. 6 illustrates a variation example of the first and second electrode pads 128 and 129 of FIG. 5, in which a concave surface R sunken inwardly without a step structure may be formed on first and second electrode pads 128' and 129'.

Particles 132 which will be described later are confined by the concave surface R, so that the light emitting device 120 may be mounted more stably. The concave surface R may be formed as a curved surface.

As another example, the light emitting device 120 may be a stacked semiconductor layer in which a plurality of light emitting diodes is disposed by being stacked.

The stacked semiconductor layer may include a first light emitting stack, a second light emitting stack, and a third light emitting stack that are sequentially stacked. The second light emitting stack may be disposed over the first light emitting stack, and the third light emitting stack may be sequentially stacked over the second light emitting stack.

Each of the first to third light emitting stacks may include the first conductivity type semiconductor layer 121, the active layer 123 and the second conductivity type semiconductor layer 122.

In addition, the light emitting device 120 may include an adhesive layer for bonding the first to third light emitting stacks, a lower contact layer, an insulation layer, and electrode pads. The electrode pads may be electrically connected to the substrate electrode E of the substrate 110.

Each of the first to third light emitting stacks may be a light emitting stack that emits red light, a light emitting stack that emits green light, and a light emitting stack that emits blue light. Therefore, a stacked light emitting device 120 including the first to third light emitting stacks may display RGB three primary colors as pixels.

The light emitting device 120 may be implemented by being modified into various structures, and it is obvious that it may be modified into a flip-chip type, a vertical type, a horizontal type, or the like. In addition, depending on the shape of the light emitting device 120, the growth substrate may be omitted.

Referring again to FIG. 1, peak wavelengths of light emitted from each of the light emitting devices 120a, 120b, and 120c disposed on the upper surface of the substrate 110 may be same or different. Alternatively, a deviation of the peak wavelengths of the plurality of light emitting devices 120a, 120b, and 120c may be within 5 nm.

As an example, one of the light emitting devices 120a, 120b, and 120c may be a diode that emits blue light, which may be a blue light emitting diode having a peak wavelength within a blue wavelength range, and a difference between the peak wavelength and a dominant wavelength of the blue light emitting diode may be between 2 nm and 15 nm. In detail, the blue light emitting diode may have the peak wavelength between 430 nm and 475 nm, and may have the dominant wavelength between 460 nm and 480 nm. When the difference in wavelength is maintained, a color deviation may be reduced, thereby enabling more vivid color expression. The peak wavelength of the blue light emitting diode may be a wavelength shorter than the dominant wavelength. Through this, luminous efficacy may be corrected while increasing light energy, thereby reducing design difficulty.

One of the light emitting devices 120a, 120b, and 120c is a diode that emits green light, which may be a green light emitting diode having a peak wavelength within a green wavelength range, and a difference between the peak wavelength and a dominant wavelength of the green light emitting diode may be between 5 nm and 20 nm. In detail, the green light emitting diode may have the peak wavelength between 510 nm and 540 nm, and may have the dominant wavelength between 525 nm and 545 nm. When the difference in wavelength is maintained, a color deviation may be reduced, thereby enabling more vivid color expression. The peak wavelength of the green light emitting diode may be a wavelength shorter than the dominant wavelength. Through this, luminous efficacy may be corrected while increasing light energy, thereby reducing design difficulty.

One of the light emitting devices 120a, 120b, and 120c is a diode that emits red light, which may be a red light emitting diode having a peak wavelength within a red wavelength range, and a difference between the peak wavelength and the dominant wavelength of the red light emitting diode may be between 5 nm and 30 nm. In detail, the red light emitting diode may have the peak wavelength between 620 nm and 640 nm, and may have the dominant wavelength between 600 nm and 630 nm. When the difference in wavelength is maintained, a color deviation may be reduced, thereby enabling more vivid color expression. The peak wavelength of the red light emitting diode may be a wavelength longer than the dominant wavelength. Through this, luminous efficacy may be corrected while increasing light energy, thereby reducing design difficulty.

The light emitting devices 120a, 120b, and 120c may be configured to emit orange light, yellow light, purple light, or ultraviolet light in addition to blue light, green light, and red light.

In order to increase a degree of integration, the light emitting device 120 may have an area of 1×10⁶µm² or less. Preferably, the area of the light emitting device 120 may be 2.5×10⁵µm² or less. More preferably, the area of the light emitting device 120 may be 2.5×10²µm² or less.

The spacer 130 includes a plurality of particles 132, and the spacer 130 is configured to physically connect the light emitting devices 120a, 120b, and 120c and the substrate 110 and various configurations thereof are possible. In detail, the spacer 130 may include the plurality of particles 132 and a polymer layer 134 surrounding the plurality of particles 132.

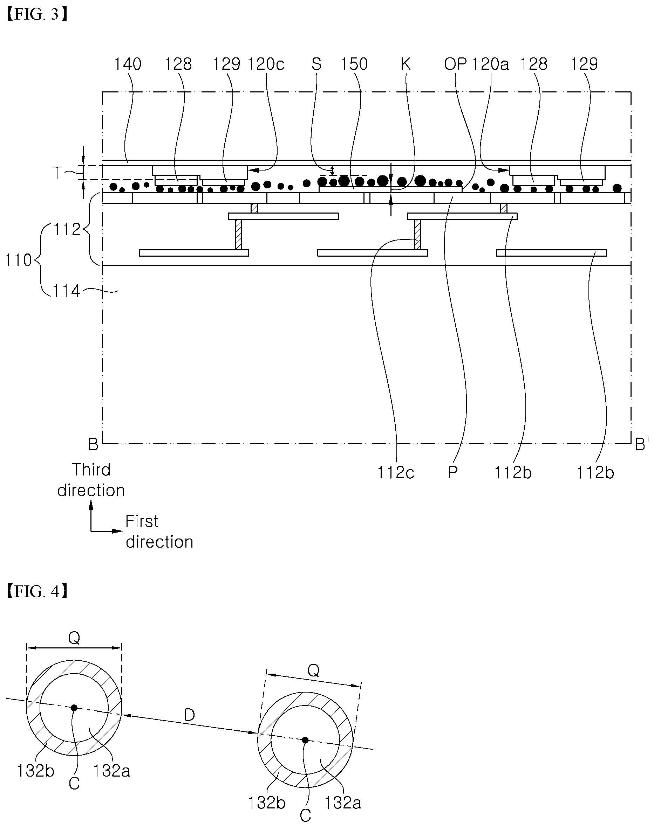

Referring to FIGs. 2 and 3, the particles 132 may be dispersed within the spacer 130. The plurality of particles 132 may include a conductive material, and may electrically connect the light emitting devices 120a, 120b, and 120c and the substrate 110. Referring to FIG. 4, the particle 132 may be a sphere having a center point C. The plurality of particles 132 may have different diameters Q and shapes. As an example, the diameter of the particle 132 may be within 15 µm. Therefore, a light scattering effect may be implemented without the particles 132 protruding from upper surfaces of the light emitting devices 120a, 120b, and 120c.

In this case, the diameter Q of the particle 132 may be smaller than a maximum thickness of the semiconductor layers 121, 122, and 123 of the light emitting device 120. In addition, a separation distance D between the particles 132 may be different from one another. Herein, the separation distance D may mean a distance between adjacent particles 132.

A ratio of the plurality of particles 132 occupied in the spacer 130 may be 0.5% to 50%. In addition, the particle 132 may have a multi-layer structure having different materials as illustrated in FIG. 4. As an example, the particle 132 may include a core layer 132a and an outer layer 132b surrounding the core layer 132a and having a different material from that of the core layer 132a. The core layer 132a may be a polymer material. The outer layer 132b may be a coating layer surrounding the core layer 132a as a layer for electrical conductivity. The outer layer 132b may include metal. As an example, the outer layer 132b may include at least one material among Ni, Au, Pd, Ti, Al, or Sn.

As a variation example, irregularities may be formed on an outer surface of the particle 132. Therefore, a surface area of an external metal of the particle 132 may be increased to lower an electrical resistance.

Portions of the particles 132 may be disposed between the first and second electrode pads 128 and 129 of the light emitting devices 120a, 120b, and 120c and one surface of the substrate 110. The particle 132 may electrically connect between the first and second electrode pads 128 and 129 and the substrate electrode E. Since the semiconductor layers 121, 122, and 123 of the light emitting devices 120a, 120b, and 120c form a mesa structure, a thickness of the spacer 130 between the first electrode pad 128 and one surface of the substrate 110 may be larger than a thickness of the spacer 130 between the second electrode pad 129 and one surface of the substrate 110.

Other portions of the particles 132 may be disposed between the light emitting devices 120a, 120b, and 120c.

The polymer layer 134 may have various configurations as a buffer layer surrounding the particles 132. The particles 132 may be dispersed within the polymer layer 134.

The polymer layer 134 may be a thermoplastic or thermosetting resin, and may include an adhesive material. As an example, the polymer layer 134 may include Si, epoxy, or others, but the inventive concepts are not limited thereto. That is, the spacer 130 may be a film layer formed into a film shape by mixing the particles 132 and a polymer.

When the spacer 130 is pressed in a particular direction while disposed between the light emitting devices 120a, 120b, and 120c and the substrate 110, it can conduct electricity in the pressing direction and may be electrically insulated in other directions. Herein, the pressing direction may be a third direction perpendicular to the first and second directions with reference to FIGs. 2 and 3. Accordingly, each of the light emitting devices 120a, 120b, and 120c may be electrically connected to the substrate 110, and may be insulated from other adjacent light emitting devices 120a, 120b, and 120c.

The spacer 130 may fill a space between the light emitting devices 120a, 120b, and 120c and a space between the light emitting devices 120a, 120b, and 120c and the substrate 110. Through the spacer 130, support and electrical connection to the light emitting devices 120a, 120b, and 120c may be achieved at once.

An upper surface of the polymer layer 134 between the light emitting devices 120a, 120b, and 120c may coincide with the upper surfaces of the light emitting devices 120a, 120b, and 120c.

The plurality of particles 132 may be positioned under the spacer 130. That is, the plurality of particles 132 may be disposed at a position closer to the substrate 110.

In this case, a virtual line M passing through a midpoint between the upper surfaces of the light emitting devices 120a, 120b, and 120c on one surface of the substrate 110 may be defined. Centers of the particles 132 positioned between the light emitting devices 120a, 120b, and 120c within one group G or pixel PX may be positioned on or below the virtual line M.

A particle 132 disposed between at least two groups G or pixels PX may be positioned higher than a particle 132 disposed between at least two light emitting devices 120a, 120b, and 120c within one group G or pixel PX. A vertical distance S from an upper vertex of the particle 132 disposed between at least two groups G or pixels PX to the upper surface of the polymer layer 134 may be smaller than a vertical distance from an upper vertex of the particle 132 disposed between at least two light emitting devices 120a, 120b, and 120c within one group G or pixel PX to the upper surface of the polymer layer 134. Therefore, a transmittance and a transparency of a region between groups G or between pixels PX may be adjusted differently.

Meanwhile, referring to FIG. 3, the substrate 110 may further include a cover layer 150 disposed on one surface of the electrode layer 112. The cover layer 150 may include an opening OP penetrated vertically for the plurality of light emitting devices 120a, 120b, and 120c to be disposed.

Two or more light emitting devices 120a, 120b, and 120c may be disposed in the opening OP. As an example, three light emitting devices 120a, 120b, and 120c may be disposed in the opening OP. In this case, the three light emitting devices 120a, 120b, and 120c may be spaced apart in the long side direction (the first direction) within the opening OP to form one group G or pixel PX. That is, the cover layer 150 may surround the light emitting devices 120a, 120b, and 120c forming one group G or pixel PX.

A thickness K of the cover layer 150 may be smaller than the diameter Q of the particle 132. In addition, on the cover layer 150, a diameter Q of at least one particle 132 may be greater than the vertical distance S from the particle 132 to the upper surface of the polymer layer 134.

As the cover layer 150 protrudes from one surface of the substrate 110, the particles 132 positioned over the cover layer 150 may be positioned higher than the particles 132 positioned between the light emitting devices 120a, 120b, and 120c within the opening OP of the cover layer 150.

The cover layer 150 is a layer surrounding the light emitting devices 120a, 120b, and 120c, which may improve a light extraction efficiency and a contrast by scattering light emitted from the light emitting devices 120a, 120b, and 120c. In particular, as the particles 132 are positioned relatively higher than other regions by the cover layer 150, a light scattering effect through the particles 132 in an upper region of the cover layer 150 may be increased.

Meanwhile, the spacer 130 may perform not only a function of supporting the light emitting devices 120a, 120b, and 120c and enabling physical connection, but also a function of heat dissipation of absorbing and dissipating heat generated during the operation of the light emitting devices 120a, 120b, and 120c. Heat generated during the operation of the light emitting devices 120a, 120b, and 120c may cause expansion/contraction of electrodes or others having a high thermal expansion rate, and may cause problems such as the light emitting devices 120a, 120b, and 120c being peeled off from the substrate 110 or structurally weak portions being damaged.

The particles 132 mixed in the spacer 130 of the present disclosure may absorb heat generated from the light emitting devices 120a, 120b, and 120c and evenly distribute the heat to disperse and alleviate thermal stress. To this end, a thermal expansion coefficient of the particle 132 may be smaller than those of the first and second electrode pads 128 and 129 of the light emitting devices 120a, 120b, and 120c. In particular, as the particle 132 has the thermal expansion coefficient relatively smaller than those of the first and second electrode pads 128 and 129 and has a spherical shape, it may receive surrounding heat, alleviate thermal expansion, and achieve more effective heat dissipation and heat distribution. Accordingly, the light emitting module 100 may be prevented from being deformed or damaged by heat generated when the light emitting devices 120a, 120b, and 120c are driven, and may be prevented from being defected due to heat. Furthermore, as the particles 132 are disposed under the spacer 130 adjacent to the substrate 110, more effective heat absorption and heat dissipation may be possible.

Meanwhile, the light emitting module 100 may further include a protection layer 140 covering the upper surfaces of the light emitting devices 120a, 120b, and 120c. The protection layer 140 may protect the light emitting module 100 from the outside by covering the light emitting devices 120a, 120b, and 120c and the spacer 130 with a thin film layer. The protection layer 140 is an optional configuration and does not necessarily have to be provided.

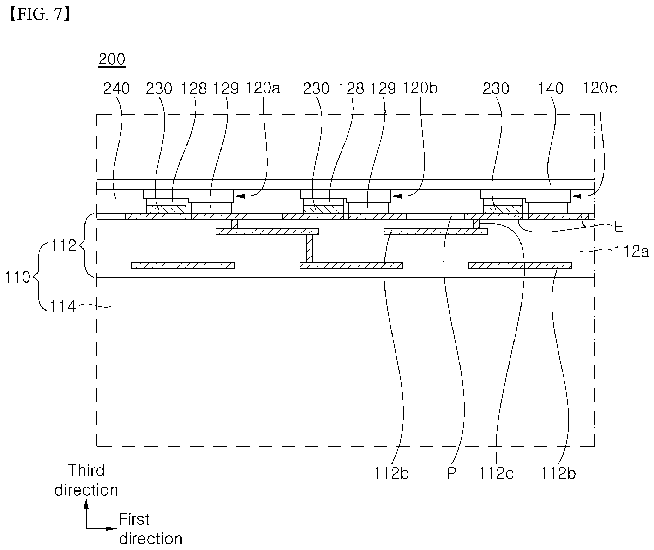

Next, FIG. 7 is a cross-sectional view illustrating a portion of a configuration of a light emitting module 200 according to another embodiment of the present disclosure, which may be configured identically or similarly to the light emitting module 100 described above, except for a spacer 230. Referring to FIG. 7, the light emitting module 200 may include a plurality of light emitting devices 120a, 120b, and 120c disposed on one surface of a substrate 110.

As a conductive material, a substrate electrode E and the spacer 230 may be disposed on the one surface of the substrate 110. The spacer 230 may electrically connect the light emitting devices 120a, 120b, and 120c and the substrate 110. In addition, the spacer 230 may physically connect the light emitting devices 120a, 120b, and 120c and the substrate 110. The spacer 230 may be formed of a single layer or a plurality of layers. FIG. 7 illustrates an example in which the spacer 230 is disposed on a side corresponding to a first electrode pad 128 of the light emitting devices 120a, 120b, and 120c, without being limited thereto, and it goes without saying that the spacer 230 may be disposed on a side corresponding to a second electrode pad 129 or may be disposed corresponding to each of the first electrode pad 128 and the second electrode pad 129.

When the spacer 230 is disposed corresponding to each of the first electrode pad 128 and the second electrode pad 129, a thickness of the spacer 230 connected to the first electrode pad 128 may be larger than that of the spacer 230 connected to the second electrode pad 129. As the light emitting devices 120a, 120b, and 120c include a mesa structure, the thickness on a side of a first conductivity type semiconductor layer 121 is configured to be thinner. Therefore, by increasing the thickness of the spacer 230 connected to the first conductivity type semiconductor layer 121, the light emitting devices 120a, 120b, and 120c can be maintained and supported horizontally while being stably fixed without damaging the thin semiconductor layer.

In addition, a width of the spacer 230 at a surface in contact with the substrate 110 and a width thereof at a surface in contact with the electrode pads 128 and 129 of the light emitting devices 120a, 120b, and 120c may be different from each other.

The light emitting module 200 may further include a molding member 240 covering the light emitting devices 120a, 120b, and 120c and the substrate 110. The molding member 240 may be transparent to light. FIG. 7 illustrates an example in which an upper surface of the molding member 240 coincides with upper surfaces of the light emitting devices 120a, 120b, and 120c, but the inventive concepts are not limited thereto. As an example, the molding member 240 may cover entire upper surfaces of the light emitting devices 120a, 120b, and 120c.

A luminous intensity of light sensed on the upper surface of the molding member 240 may have a value different from a luminous intensity of light sensed on the other surface (a surface opposite to one surface) of the substrate 110.

A light emission pattern in a direction of the upper surface of the molding member 240 may be different from a light emission pattern on the other surface (the surface opposite to one surface) of the substrate 110. A beam angle in the direction of the upper surface of the molding member 240 may be different from a beam angle on the other surface (the surface opposite to one surface) of the substrate 110. A surface uniformity (or roughness, RMS) on the upper surface of the molding member 240 and a surface uniformity (or roughness, RMS) on the other surface of the substrate 110 may be different.

The molding member 240 may include particles. The particles may be light-reflecting or light-absorbing materials. The particles may change a light path, or may change (reduce or increase) an amount of light emitted to the outside.

The light emitting module 200 may include the plurality of light emitting devices 120a, 120b, and 120c disposed on one surface of the substrate 110. Since the semiconductor layer of the light emitting devices 120a, 120b, and 120c has a mesa structure, a distance between the first conductivity type semiconductor layer 121 of the light emitting devices 120a, 120b, and 120c and one surface of the substrate 110 may be different from a distance between the second conductivity type semiconductor layer 122 and one surface of the substrate 110. For example, a first region is a region between an exposed region of the first conductivity type semiconductor layer 121 and one surface of the substrate 110, and a distance from the exposed region of the first conductivity type semiconductor layer 121 to one surface of the substrate 110 may be defined as a first distance. Similarly, a second region is a region between the second conductivity type semiconductor layer 122 and one surface of the substrate 110, and a distance from the second conductivity type semiconductor layer 122 to one surface of the substrate 110 may be defined as a second distance. In this case, the first and second distances may be different. The first distance may be greater than the second distance.

In the light emitting module 200, a light-reflecting material (e.g., the electrode pads 128 and 129, the spacer 230, or others) may be disposed between the substrate 110, which is a first light-transmitting material, and the semiconductor layer of the light emitting devices 120a, 120b, and 120c, which is a second light-transmitting material. However, it is not necessarily limited thereto, and a light-transmitting material (e.g., an ohmic electrode 124 or the like) may be disposed between the substrate 110, which is the first light-transmitting material, and the semiconductor layer of the light emitting devices 120a, 120b, and 120c, which is the second light-transmitting material.

An insulation material may be further disposed on one surface of the substrate 110. The insulation material may be resin, PSR, polymer, silicone, or the like. The insulation material may surround side surfaces of the substrate electrode E, and may extend into a space between the substrate electrodes E. The insulation material may expose an upper surface of the substrate electrode E, and the substrate electrode E may form an electrical connection with the light emitting devices 120a, 120b, and 120c on an exposed upper surface. The insulation material may be a light-transmitting material. A refractive index of the insulation material may be different from those of the semiconductor layers 121, 122, and 123 of the light emitting devices 120a, 120b, and 120c. The refractive index of the insulation material may be different from that of the substrate 110. A light transmittance of the insulation material may be different from that of the substrate 110.

The insulation material may be a light-transmitting material. The refractive index of the insulation material may be different from that of the first conductivity type semiconductor layer 121, the second conductivity type semiconductor layer 122, or the active layer 123 of the light emitting devices 120a, 120b, and 120c. The refractive index of the insulation material may be different from that of the substrate 110. The light transmittance of the insulation material may be different from that of the substrate 110. The insulation material may have a dispersion characteristic with respect to light emitted from the light emitting devices 120a, 120b, and 120c.

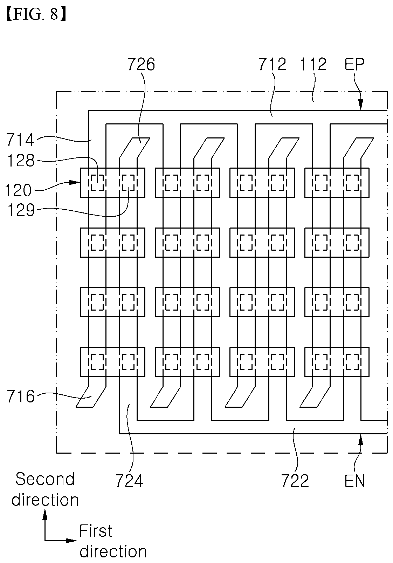

FIG. 8 is a plan view showing substrate electrodes EP and EN disposed on one surface of the substrate 110 of the light emitting module 200, where one of the substrate electrodes EP and EN may be a first substrate electrode EN, and the other may be a second substrate electrode EP having a different polarity from that of the first substrate electrode EN.

The first substrate electrode EN may include a first main electrode 722 disposed on one side of the substrate 110 and a second extension electrode 724 formed along a second direction in which light emitting devices 120 are arranged and extending from the first main electrode 722.

The second substrate electrode EP may include a second main electrode 712 disposed on one side of the substrate 110 and a second extension electrode 714 formed along the second direction in which the light emitting devices 120 are arranged and extended from the second main electrode 712.

The first and second extension electrodes 724 and 714 may be provided as a single number or may be branched into a plurality of numbers from one first or second main electrode 722 or 712. When the light emitting module 200 includes a plurality of first and second extension electrodes 724 and 714, the first and second extension electrodes 724 and 714 may be disposed alternately. In this case, the plurality of first and second extension electrodes 724 and 714 may include a first region disposed parallel to each other and a second region in which a distance between one extension electrode 724 or 714 and an adjacent extension electrode 724 or 714 varies.

Alternatively, the first and second main electrodes 722 and 712 may include first and second portions having different widths. Alternatively, the first and second extension electrodes 724 and 714 may include first and second portions having different widths. Alternatively, the first and second extension electrodes 724 and 714 may include bending portions 726 and 716 that are bent so as to face different directions. A portion of the first extension electrode 724 may be extended toward the second extension electrode 714 through the bending portion 726. A portion of the second extension electrode 714 may be extended toward the first extension electrode 724 through the bending portion 716.

The light emitting devices 120 may be disposed on the first extension electrode 714 and the second extension electrode 724, and the first and second electrode pads 128 and 129 of the light emitting devices 120 may be electrically connected to the first extension electrode 714 and the second extension electrode 724, respectively. It goes without saying that the first extension electrode 714 and the second extension electrode 724 and the first and second electrode pads 128 and 129 may be electrically connected and supported through the spacer 130 and 230 described above.

The light emitting modules 100 and 200 described above may be applied to various light emitting apparatuses such as a display apparatus, lighting, a lamp, and others.

Although the present disclosure has been described above with reference to preferred embodiments, it will be understood by those skilled in the art or having ordinary knowledge in the art that various modifications and changes may be made to the present disclosure without departing from the spirit and technical scope of the present disclosure as set forth in the claims below.

Therefore, the technical scope of the present disclosure should not be limited to the contents described in the detailed description of the specification, but should be defined by the scope of the patent claims.

## Claims

1. A light emitting module, comprising: a substrate, a plurality of light emitting devices, and a spacer disposed between one surface of the substrate and the plurality of light emitting devices, wherein:
the spacer includes a plurality of particles, and
diameters of the plurality of particles are smaller than a maximum thickness of a semiconductor layer of the light emitting device.

2. The light emitting module of claim 1,
wherein the spacer further comprises a polymer layer surrounding the plurality of particles.

3. The light emitting module of claim 1,
wherein an upper surface of the polymer layer between the plurality of light emitting devices coincides with an upper surface of the light emitting device.

4. The light emitting module of claim 1,
wherein the plurality of particles is disposed under the spacer.

5. The light emitting module of claim 1,
wherein separation distances between the plurality of particles are different from one another.

6. The light emitting module of claim 1,
wherein the diameters of the plurality of particles are different from one another.

7. The light emitting module of claim 1,
wherein with respect to a virtual line passing through a midpoint between the upper surface of the light emitting device on one surface of the substrate, centers of the plurality of particles are positioned on or below the virtual line.

8. The light emitting module of claim 1,
wherein the substrate comprises an electrode layer comprising a substrate electrode electrically connected to an electrode pad of the light emitting device, a main insulation layer disposed under the electrode layer, and a cover layer disposed over the electrode layer.

9. The light emitting module of claim 8, wherein:
the cover layer comprises an opening vertically penetrated for the plurality of light emitting devices to be disposed, and
two or more light emitting devices are disposed in the opening.

10. The light emitting module of claim 9,
wherein a thickness of the cover layer is smaller than the diameter of the particle.

11. The light emitting module of claim 9, wherein:
the spacer further comprises a polymer layer surrounding the plurality of particles, and
on the cover layer, the diameter of the particle is larger than a vertical distance from the particle to the upper surface of the polymer layer.

12. The light emitting module of claim 9, wherein:
the light emitting device has a rectangular shape having a long side and a short side on a plane, and
two or more light emitting devices are spaced apart along a long side direction within the opening.

13. The light emitting module of claim 12,
wherein the particles disposed over the cover layer are positioned higher than the particles positioned between the light emitting devices within the opening.

14. The light emitting module of claim 1,
wherein a thermal expansion coefficient of the particle is smaller than that of the electrode pad of the light emitting device.

15. The light emitting module of claim 14,
wherein the particle comprises a core layer and an outer layer surrounding the core layer and having a material different from that of the core layer.

16. The light emitting module of claim 1,
wherein the particle is a sphere having a center point.

17. The light emitting module of claim 16,
wherein irregularities are formed on an outer surface of the particle.

18. The light emitting module of claim 1, wherein:
portions of the plurality of particles are disposed between the electrode pad of the light emitting device and one surface of the substrate, and
the electrode pad has a concave surface formed on a surface facing the substrate.

19. The light emitting module of claim 18,
wherein a step structure is formed on the concave surface.

20. The light emitting module of claim 1, wherein:
the light emitting device comprises a first conductivity type semiconductor layer, a second conductivity type semiconductor layer, an active layer disposed between the first conductivity type semiconductor layer and the second conductivity type semiconductor layer, a first electrode pad disposed on an exposed region of the first conductivity type semiconductor layer exposed by etching the second conductivity type semiconductor layer and the active layer, and a second electrode pad disposed on the second conductivity type semiconductor layer, and
a thickness of the spacer between the first electrode pad and one surface of the substrate is larger than that of the spacer between the second electrode pad and one surface of the substrate.
